# EUROPÄISCHE PATENTSCHRIFT

(11) **EP 2 558 609 B1**
(45) Veröffentlichungstag und Bekanntmachung des Hinweises auf die Patenterteilung: **28.09.2016**
(21) Anmeldenummer: 11713196.1
(22) Anmeldetag: 07.04.2011
(51) Int. Cl.: C23C 14/34, C23C 16/503

(54) **VERFAHREN ZUM BESCHICHTEN EINES SUBSTRATES INNERHALB EINER VAKUUMKAMMER MITTELS PLASMAUNTERSTÜTZER CHEMISCHER DAMPFABSCHEIDUNG**
METHOD FOR COATING A SUBSTRATE INSIDE A VACUUM CHAMBER BY MEANS OF PLASMA-ASSISTED CHEMICAL VAPOR DEPOSITION
PROCÉDÉ POUR REVÊTIR UN SUBSTRAT À L'INTÉRIEUR D'UNE CHAMBRE À VIDE AU MOYEN D'UN DÉPÔT CHIMIQUE EN PHASE VAPEUR ASSISTÉ PAR PLASMA

(30) Priorität: 16.04.2010 DE 102010015149
(43) Veröffentlichungstag der Anmeldung: 20.02.2013
(73) Patentinhaber: Fraunhofer-Gesellschaft zur Förderung der angewandten Forschung e.V., 80686 München (DE)
(72) Erfinder: FAHLAND, Matthias, 01257 Dresden (DE); BUNK, Sebastian, 01217 Dresden (DE); FAHLTEICH, John, 01279 Dresden (DE); BLÜTHNER, Ralf, 01445 Radebeul (DE); ZEIBE, Rainer, 01471 Radeburg (DE)
(86) Internationale Anmeldenummer: PCT/EP2011/001758
(87) Internationale Veröffentlichungsnummer: WO 2011/128044

(56) Entgegenhaltungen:
- EP-A1- 1 849 887
- DE-A1-102008 028 542
- JP-A- 57 076 183
- US-A- 4 606 802
- US-A1- 2002 033 480

## Beschreibung

Die Erfindung betrifft ein Verfahren zum Abscheiden von dünnen Schichten im Vakuum mittels plasmaunterstützter chemischer Dampfabscheidung (engl. plasma enhanced chemical vapour deposition, im Folgenden kurz PECVD genannt).

### Stand der Technik

Verfahren zur chemischen Dampfabscheidung sind sehr gut bekannt. Bei vielen Ausführungen beruht die Beschichtung darauf, dass ein zu beschichtendes Substrat auf eine erhöhte Temperatur gebracht wird. Diese erhöhte Temperatur führt zu einer chemischen Reaktion an der Oberfläche des Substrats zwischen verschiedenen gasförmigen Ausgangsstoffen. Die bei dieser Reaktion entstehenden Reaktionsprodukte werden zumindest teilweise als Schicht auf dem Substrat abgeschieden. Üblicherweise läuft dieser Prozess in einem abgeschlossenen Gefäß, einem sogenannten Rezipienten ab.

Bei vielen technischen Anwendungen stellt die Notwendigkeit der Erhöhung der Substrattemperatur ein technisches Problem dar. Das trifft insbesondere dann zu, wenn das Substrat aus einem Kunststoff oder einem anderen temperaturempfindlichen Material besteht. Aus diesem Grunde wurde die plasmaunterstützte chemische Dampfabscheidung (PECVD) entwickelt. Hierbei wird die Energie, die notwendig ist, um eine Reaktion zwischen den gasförmigen Ausgangsstoffen durchzuführen, zumindest teilweise über die Einwirkung eines Plasmas zugeführt. Im Ergebnis reicht eine geringere Substrattemperatur aus als bei den thermischen CVD-Verfahren oder es kann gar auf jegliche Erwärmung des Substrates verzichtet werden.

Verfahren für PECVD-Prozesse können nach der Art der Plasmaerzeugung unterschieden werden. Weit verbreitet sind Hochfrequenzplasmen, bei denen die Energiezufuhr in einem elektrischen Wechselfeld mit einer Frequenz zwischen 2 MHz und 100 MHz erfolgt. Weitere bekannte Vorrichtungen verfügen über eine Mikrowellenanregung, wobei ein elektrisches Wechselfeld mit einer Frequenz von 2.41 GHz üblich ist. Üblicherweise wird hierbei im Rezipienten zunächst ein Vakuum erzeugt. Anschließend werden kontinuierlich die für die chemische Reaktion erforderlichen Ausgangsstoffe zugeführt und die gasförmigen Reaktionsprodukte abgepumpt.

Andere Verfahren für PECVD-Prozesse nutzten ein elektrisches Wechselfeld im Bereich zwischen 10 und 200 kHz (im Folgenden als Mittelfrequenz bezeichnet). Bei der Verwendung der Mittelfrequenz ist es üblich, die elektrische Leistung zwischen zwei Elektroden mit überlagertem Magnetfeld oder zwischen einer Elektrode mit überlagertem Magnetfeld und einer weiteren magnetfeldfreien Elektrode anzulegen. Die Überlagerung einer Elektrode mit einem Magnetfeld dient zur Erhöhung der Ladungsträgerdichte in der Nähe dieser Elektrode. Solche Einrichtungen sind in der Technik gut bekannt und werden als Magnetron bezeichnet.

Einrichtungen für einen PECVD-Prozess mit einem oder mehreren Magnetrons (auch Magnetron-PECVD-Prozess genannt), die mit einem elektrischen Wechselfeld in Mittelfrequenz betrieben werden, sind insbesondere dann von Vorteil, wenn relativ große Flächen mit einer Einrichtung beschichtet werden sollen. Das Substrat wird dabei an dem Magnetron vorbei bewegt. Mit solchen Einrichtungen können Beschichtungsbreiten von mehr als einem Meter realisiert werden. Eine solche Vorrichtung ist beispielsweise in DE 26 08 415 A1 beschrieben. DE 10 2008 028 542 A1 beschreibt Magnetron-PECVD-Prozesse, bei denen zumindest der Bereich der Einlassöffnung, durch welche ein Ausgangsmaterial für chemische Schichtabscheidung in eine Vakuumkammer strömt, als Elektrode einer Gasentladung geschaltet wird. Mittels dieser Vorgehensweise kann ein höherer lonisierungsgrad des in die Vakuumkammer strömenden Ausgangsmaterials erzielt werden.

Vorrichtungen, bei denen eine chemische Schichtabscheidung durch ein Magnetronplasma unterstützt wird, unterscheiden sich im Wesentlichen in zwei Arten. Bei einer ersten Ausführungsform wird das Magnetron sowohl zum Ausbilden eines Plasmas als auch zum Bereitstellen von für einen Schichtaufbau erforderlichen Materialkomponenten verwendet, indem von einem zum Magnetron gehörenden Target Materialpartikel durch Magnetronsputtern abgestäubt werden, die dann in die durch chemische Reaktionen auf einem Substrat abgeschiedenen Schichtkomponenten eingelagert werden. Eine derartige Vorrichtung ist beispielsweise aus DE 198 24 364 A1 bekannt. DE 10 2007 021 A1 offenbart ebenfalls eine solche Vorrichtung. Mit dieser werden auf einem Substrat mittels eines PECVD-Prozesses Schichtkomponenten abgeschieden, in welche Silberpartikel eingelagert werden, die vom Magnetrontarget abgestäubt werden. Auf diese Weise erhält die abgeschiedene Schicht antimikrobielle Eigenschaften.

Eine zweite Gruppe von Vorrichtungen zum Ausführen von Magnetron-PECVD-Prozessen zeichnet sich dadurch aus, dass bei diesen mittels des Magnetrons lediglich ein Magnetronplasma ausgebildet wird. Ein Sputterabtrag vom Magnetrontarget ist hingegen nicht angestrebt. Der Schichtaufbau erfolgt somit ausschließlich aus einer chemischen Dampfabscheidung (DE 10 2004 005 313 A1).

Allen oben angeführten Arten von Vorrichtungen und Verfahren zum Ausführen von PECVD-Prozessen haftet der Nachteil an, dass der Abscheideprozess in seiner Leistungsfähigkeit durch Instabilitäten beschränkt ist. Diese Instabilitäten äußern sich im Betrieb des Prozesses durch ein Absinken der Entladungsspannung innerhalb einer Zeit von weniger als einer Mikrosekunde. Dieses Absinken hat seine Ursache darin, dass sich das Plasma nicht mehr gleichmäßig über die Magnetronoberfläche verteilt, sondern sich in einem Punkt zusammenzieht. Ein solches Ereignis ist bei Plasmaprozessen bekannt und wird als Arc bezeichnet. Elektrische Leistungsversorgungen für Plasmaprozesse reagieren auf Arcs, indem sie kurzzeitig die Leistungszufuhr unterbrechen und nach einigen Mikrosekunden neu starten. Die beschriebenen Instabilitäten treten erfahrungsgemäß in umso stärkerem Maße auf, je mehr Ausgangsstoffe für die chemische Reaktion zugeführt werden. Sie begrenzen damit die durch den Prozess erreichbare Abscheiderate.

Ein weit verbreiteter Aufbau von Magnetrons umfasst einen Grundkörper, einen Kühlkörper und ein Target. Der Grundkörper ist so aufgebaut, dass er das Magnetfeld ausbildet. Er kann gleichzeitig eine Reihe konstruktiver Belange, wie zum Beispiel Befestigungen erfüllen. Das Target wird im Prozess mit einer elektrischen Spannung beaufschlagt und ist einem Beschuss von Plasmakomponenten ausgesetzt. Um eine Erwärmung des Magnetrons im Allgemeinen und des Targets im Speziellen zu verhindern, ist ein Kontakt vom Target zu einem Kühlkörper nötig. Die Kühlung des Targets schützt einerseits temperaturempfindliche Teile des Magnetrons und verhindert andererseits das Schmelzen des Targets. Bei einigen bekannten Vorrichtungen wird das Target auch gekühlt, um die Prozessstabilität zu erhöhen bzw. die Arcrate zu senken. Üblicherweise wird ein Target bei einer Vorrichtung aus dem Stand der Technik während eines Beschichtungsvorgangs auf eine Temperatur von etwa 100 °C ± 50 °C gekühlt.

### Aufgabenstellung

Der Erfindung liegt daher das technische Problem zugrunde, ein Verfahren zum Ausführen von PECVD-Prozessen zu schaffen, mittels der die Nachteile aus dem Stand der Technik überwunden werden. Insbesondere sollen mit einer erfindungsgemäßen Vorrichtung großflächige Substrate mit einer gegenüber dem Stand der Technik höheren Prozessstabilität beschichtet werden können. D. h., bei dem erfindungsgemäßen Verfahren sollen gegenüber dem Stand der Technik weniger Arcs pro Zeiteinheit auftreten. Ebenfalls soll die bei einem Beschichtungsprozess erreichbare Abscheiderate erhöht werden.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Patentansprüchen.

Das erfindungsgemäße Verfahren erfolgt mittels einer Vorrichtung zum Abscheiden einer Schicht auf einem Substrat innerhalb einer Vakuumkammer mittels plasmaunterstützter chemischer Dampfabscheidung, welche mindestens einen Einlass zum Einlassen mindestens eines Gases in die Vakuumkammer sowie mindestens ein mit einem Target bestücktes Magnetron zum Erzeugen des Plasmas umfasst. Das erfindungsgemäße Verfahren gehört somit zu jener Gruppe von Verfahren zum Durchführen von Magnetron-PECVD-Prozessen.

Während bei Verfahren aus dem Stand der Technik das Target eines Magnetrons auf etwa 100 °C herunter gekühlt wird, konnte überraschend festgestellt werden, dass es bei einem Magnetron-PECVD-Prozess hinsichtlich der Arcrate vorteilhaft ist, wenn das Target oder zumindest ein Teilbereich des Targets ein Vielfaches der Temperatur von 100 °C aufweist. Bei einer Targettemperatur von 300 °C konnte beobachtet werden, dass sich die Anzahl von Arcs pro Zeiteinheit gegenüber dem Stand der Technik bereits mehr als halbiert hatte, was mit einer Verbesserung der Prozessstabilität einhergeht. Bei einer erfindungsgemäßen Vorrichtung weist das Target eines Magnetrons daher während des Abscheidens der Schicht zumindest in einem Bereich eine Temperatur von mindestens 300 °C auf.

Durch ein weiteres Erhöhen der Targettemperatur kann eine weitere Reduzierung der Arcrate realisiert werden. Bei einer Ausführungsform weist das Target eines Magnetrons während des Abscheidens der Schicht zumindest in einem Bereich eine Temperatur von mindestens 500 °C auf. Mit Targettemperaturen in dieser Höhe konnte die Arcrate gegenüber dem Stand der Technik auf weniger als ein Zehntel reduziert werden.

Das erfindungsgemäße Verfahren gehört zu jener Gattung von Verfahren für das Durchführen von Magnetron-PECVD-Prozessen, bei denen ein Magnetron derart konfiguriert ist, dass mit diesem lediglich ein Magnetronplasma ausgebildet wird. Ein Sputterabtrag vom zugehörigen Target und ein Beitrag von Targetpartikeln am Schichtaufbau werden hingegen nicht beabsichtigt. Für ein erfindungsgemäßes Verfahren eignen sich daher besonders solche Targetmaterialien, deren Partikel sich nur schwer von der Targetoberfläche abstäuben lassen. Besonders geeignet sind daher als Targetmaterial beispielsweise Titan oder Zirkon.

Wenn das Erhöhen der Targettemperatur beim erfindungsgemäßen Verfahren gegenüber dem Stand der Technik auch positiv hinsichtlich der Arcrate ist, stellt diese Temperaturerhöhung auch eine Gefahr hinsichtlich einer möglichen thermischen Beschädigung eines zu beschichtenden Substrates dar, insbesondere wenn es sich beispielsweise um ein Kunststoffsubstrat handelt. Es ist deshalb vorteilhaft, wenn nicht das gesamte Target eine Temperatur von mindestens 300 °C aufweist, sondern nur Teilbereiche des Targets, wobei die übrigen Teilbereiche des Targets so wie beim Stand der Technik auf etwa 100 °C gekühlt werden.

So ist es beispielsweise hinreichend für das Verringern der Arcrate gegenüber dem Stand der Technik, wenn insbesondere Oberflächenbereiche des Targets, in denen der Erosionsgraben beim Magnetronsputtern verlaufen würde, eine Temperatur von über 300 °C aufweisen.

Bei einer weiteren Ausführungsform besteht das Target daher aus mehreren Teiltargets, von denen mindestens eines während des Beschichtungsvorgangs eine Temperatur von mindestens 300 °C aufweist.

Das Erhitzen eines Targets bzw. eines Teiltargets während eines Beschichtungsvorgangs auf mindestens 300 °C stellt bekanntermaßen kein größeres Problem dar, erfolgt dieses doch bei der Plasmaausbildung automatisch infolge des Beschusses der Targetoberfläche mit Ladungsträgern. Beim erfindungsgemäßen Verfahren muss somit nur realisiert werden, dass das Target oder mindestens ein Teiltarget nur weniger gekühlt wird als beim Stand der Technik.

Soll ein Teiltarget weniger gekühlt werden als die übrigen Teiltargets, kann dies beispielsweise umgesetzt werden, indem das Teiltarget mit einem schlechteren Wärmeübergang zur Kühleinrichtung bzw. zum Kühlkörper hin ausgebildet wird als die anderen Teiltargets. Als Kühleinrichtung bzw. Kühlkörper können beim erfindungsgemäßen Verfahren alle Einrichtungen verwendet werden, wie sie auch im Stand der Technik üblich sind. Eine andere Möglichkeit hinsichtlich des unterschiedlichen Erhitzens von Teiltargets besteht darin, zumindest ein Teiltarget aus einem Material mit schlechterer Wärmeleitfähigkeit als bei den anderen Teiltargets auszubilden.

In vielen bekannten Anwendungsfällen besteht ein Target aus einem massiven Block des Targetmaterials. Bei einer weiteren Ausführungsform der Erfindung wird aus solch einem massiven Block des Targetmaterials zumindest in einem Teilbereich der Targetoberfläche, in dem der Erosionsgraben beim Magnetronsputtern verlaufen würde, Targetmaterial entfernt. Dies kann beispielsweise mittels Fräsen erfolgen. Das Targetmaterial wird jedoch nicht durch die gesamte Dicke des Targetmaterials hindurch herausgefräst, sondern nur ein Teilbereich der Targetmaterialdicke, so dass unten am Target noch eine geschlossene Fläche des Targetmaterials am Kühlkörper eines Magnetrons anliegt. Der Targetmaterialblock mit dem ausgefrästen Teilbereich oder mit mehreren ausgefrästen Teilbereichen wird nachfolgend als Targetgrundkörper bezeichnet. Am Targetgrundkörper werden nun die Teilbereiche, in denen Targetmaterial entfernt wurde, mit separaten Teiltargets aufgefüllt. Ein Teiltarget weist dabei vorteilhafterweise jeweils die Form auf, wie die Form des ausgefrästen Teilbereichs des Targetgrundkörpers, in der das Teiltarget eingefügt werden soll. Ein Teiltarget kann beispielsweise mittels Schraub-, Klemm- oder Schraub-Klemmverbindungen am Targetgrundkörper befestigt sein. Der Vollständigkeit halber sei an dieser Stelle erwähnt, dass hier im Text zur besseren Unterscheidung der mechanischen Targetbestandteile zwar nur die in den Targetgrundkörper eingefügten Targetelemente als Teiltargets bezeichnet werden, dass der Targetgrundkörper selber aber in elektrischer Hinsicht bezüglich der Ausbildung eines Mangetronplasmas selbstverständlich ebenfalls ein Teiltarget darstellt.

Bevor ein Teiltarget in einen ausgefrästen Bereich des Targetgrundkörpers eingefügt wird, ist es vorteilhaft, am Boden des ausgefrästen Bereichs ein mechanisches Federelement anzuordnen. Je nachdem wie fest dann ein Teiltarget mittels Schraub-, Klemm- oder Schraub-Klemmverbindungen über das mechanische Federelement an den Boden des ausgefrästen Bereichs des Targetgrundkörpers gepresst wird, kann der Grad des mechanischen Kontaktes des Teiltargets zum Targetgrundkörper, somit der Grad des Wärmeübergangs vom Teiltarget zum Targetgrundkörper und folglich der Grad der Kühlung des Teiltargets eingestellt werden. Je fester ein Teiltarget an den Targetgrundkörper gepresst wird, umso stärker wird das Teiltarget gekühlt und umgekehrt.

Alternativ kann aber auch über die Art und die Anzahl verwendeter mechanischer Federelemente die Gesamtfläche, auf welcher die Federelemente einen Berührungskontakt mit einem angrenzenden Teiltarget auf der einen Seite und einem Targetgrundkörper auf der anderen Seite haben, eingestellt und somit auch die Größe des Wärmeübergangs vom Teiltarget zum Targetgrundkörper eingestellt werden.

Auf diese zwei Weisen (Anpressdruck der Verbindungselemente sowie Auswahl von Anzahl und Art mechanischer Federelemente) kann eingestellt werden, auf wieviel Grad ein Teiltarget während des Beschichtungsvorganges erhitzt werden soll. Gleichzeitig kann der Targetgrundkörper wie beim Stand der Technik üblich, auf etwa 100 °C gekühlt werden. Bei einem weiteren Ausführungsbeispiel weisen daher mindestens zwei Teiltargets während eines Beschichtungsvorganges eine Temperaturdifferenz von mindestens 200 Grad auf. Somit kann einerseits sichergestellt werden, dass die thermische Belastung für ein zu beschichtendes Substrat nicht zu hoch wird, andererseits kann die Arcrate aufgrund der höheren Temperatur eines oder mehrerer Teiltargets im Bereich des verlaufenden Sputtererosionsgrabens drastisch reduziert und somit die Prozessstabilität erhöht werden. Mit einer erfindungsgemäßen Vorrichtung können daher auch alle Arten von Substraten, die aus dem Stand der Technik bekannt sind (einschließlich Kunststoffsubstraten), beschichtet werden.

### Ausführungsbeispiel

Die Erfindung wird nachfolgend anhand bevorzugter Ausführungsbeispiele näher erläutert. Die Fig. zeigen:
- Fig. 1: eine schematische Darstellung einer Vorrichtung zum Durchführen des erfindungsgemäßen Verfahrens;
- Fig. 2: eine schematische Darstellung der Draufsicht eines Targets von einer alternativen Vorrichtung;
- Fig. 3: eine partielle schematische Schnittdarstellung durch die Dicke des Targets aus Fig. 2.

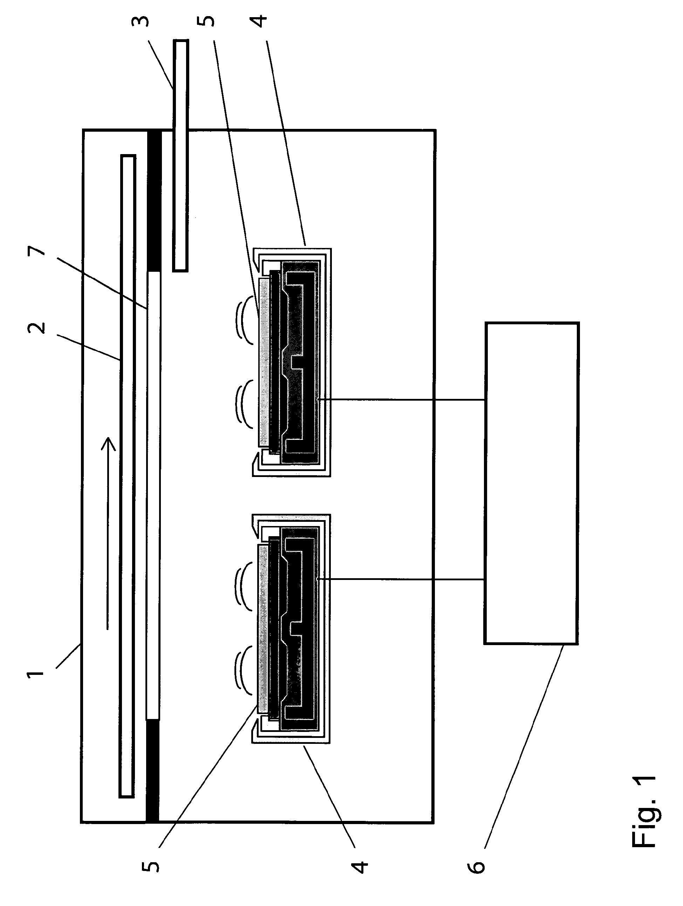

In Fig. 1 ist eine Vorrichtung zum Durchführen des erfindungsgemäßen Verfahrens schematisch dargestellt. In einer Vakuumkammer 1 soll ein Substrat 2 mit einer siliziumhaltigen Schicht durch eine plasmaunterstützte chemische Dampfabscheidung beschichtet werden. Dazu wird das Substrat 2 während dieses Beschichtungsvorganges (Beschichtungsvorgang A) mit einer Geschwindigkeit von einem Meter pro Minute in Pfeilrichtung bewegt.

Durch einen Einlass 3 wird ein Gasgemisch, welches zu gleichen Anteilen aus Sauerstoff, Argon und dem Monomer Hexamethydisiloxan (HMDSO) besteht, in die Vakuumkammer eingelassen, in welcher ein Druck von 3 Pa aufrechterhalten wird. Von dem siliziumhaltigen Monomer HMDSO werden 200 sccm zugeführt.

Zum Erzeugen eines Plasmas, welches chemische Reaktionen von Gaspartikeln innerhalb der Vakuumkammer 1 anregt, sind zwei Magnetrons 4, in Bewegungsrichtung des Substrates 2 betrachtet, nacheinander angeordnet. Beide Magnetrons 4 sind jeweils mit einem massiven Titantarget 5 bestückt und weisen jeweils eine Länge von 900 mm und eine Breite von 190 mm auf. Die Längsrichtung der Magnetrons 4 erstreckt sich in Fig. 1 in die Bildtiefe. Beide Magnetrons 4 sind derart ausgebildet und werden bezüglich der elektrischen Leistung derart betrieben, dass diese lediglich das Magnetronplasma ausbilden. Ein Sputterabtrag von den Titantargets 5 und somit ein Anteil von Titanpartikeln am Schichtaufbau ist hingegen nicht erwünscht, auch wenn sich dies nicht immer vollständig vermeiden lässt. Der Anteil der eventuell dennoch vom Target abgestäubten Titanpartikel ist vernachlässigbar klein.

Mittels einer Stromversorgungseinrichtung 6 wird eine Wechselspannung von 50 kHz zwischen beiden Magnetrons 4 angelegt und damit eine elektrische Leistung von 15 kW im erzeugten Magnetronplasma umgesetzt. Zwischen dem Substrat 2 und den Magnetrons 4 ist ferner eine Blende mit einer Blendenöffnung 7 angeordnet, welche die Geometrie eines Beschichtungsfensters für das Substrat 2 definiert.

Eine in Fig.1 nicht dargestellte aber wie auch im Stand der Technik zu jedem Magnetron 4 gehörende Kühleinrichtung ist derart dimensioniert, dass sich die dem Magnetronplasma zugewandten Oberflächenbereiche der Targets 5 während des Beschichtungsvorgangs auf eine Temperatur von 700 °C ± 30 °C erhitzen. Mit dieser Vorrichtungskonfiguration wird auf dem Substrat 2 eine 200 nm dicke siliziumhaltige Schicht abgeschieden, wobei während des Beschichtungsvorgangs Arcs mit einer Häufigkeit von 10 bis 20 Arcs pro Sekunde gezählt wurden.

Ein ähnlicher Beschichtungsvorgang (Beschichtungsvorgang B) wurde zuvor mit einer Vorrichtungskonfiguration nach dem Stand der Technik durchgeführt. Der einzige Unterschied zu dem vorhergehend zu Fig. 1 beschriebenen Vorrichtungsaufbau bestand darin, dass die zu den Magnetrons 4 gehörenden Kühleinrichtungen derart ausgebildet waren, dass während des Beschichtens nur eine Targettemperatur von etwa 100 °C erzielt wurde. Bei diesem Beschichtungsvorgang wurden Arcs noch mit einer Häufigkeit von bis zu 200 Arcs pro Sekunde gezählt. Dadurch kann die Qualität einer abgeschiedenen Schicht erheblich vermindert werden, da jeder Arc mit einer starken Veränderung der Abscheidebedingungen für die Schicht verbunden ist. Die Häufigkeit der Arcs kann zwar verringert werden, indem man die Targets bereits nach kurzer Prozesszeit reinigt oder die Abscheiderate reduziert, beides ist jedoch für das Betreiben eines Produktionsprozesses nicht wünschenswert.

Beim Beschichten mit der Vorrichtung gemäß Fig. 1, bei welcher Arcs nur noch mit einer Häufigkeit von bis zu 20 Arcs pro Sekunde auftraten, kann somit eine höhere Schichtqualität erzielt werden. Desweiteren verlängern sich beim erfindungsgemäßen Verfahren aufgrund der geringeren Arcrate die Zyklen für das Reinigen der Targets 5, was sich positiv auf die Produktivität auswirkt.

Nachfolgend wird ein Beschichtungsvorgang (Beschichtungsvorgang C) beschrieben, der mittels einer Vorrichtung durchgeführt wurde, deren schematische Darstellung mit der schematischen Darstellung der Vorrichtung aus Fig. 1 identisch ist. Bezüglich der Vorrichtung aus Fig.1 unterscheidet sich die Vorrichtung vom Beschichtungsvorgang C lediglich in den Abmessungen der Magnetrons 4, die beim Beschichtungsvorgang C jeweils ein Länge von 350 mm und eine Breite von 121 mm aufweisen, und in der Ausgestaltungsform der für die Magnetrons verwendeten Targets.

Wurden bei den Beschichtungsvorgängen A und B jeweils Targets 5 aus einem massiven Block des Materials Titan verwendet, so weist die Vorrichtung für den Beschichtungsvorgang C zwei Targets 9 auf, die jeweils aus mehreren Teiltargets bestehen.

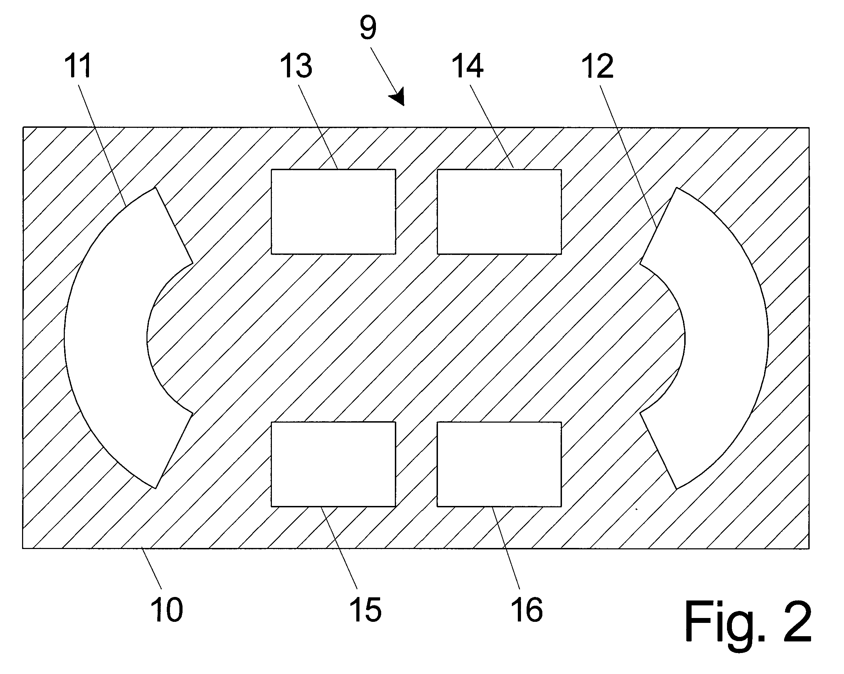

Ein solches Teiltarget 9 ist in Fig. 2 schematisch in einer Draufsicht dargestellt, d. h. es ist jene Oberfläche zu sehen, über der das Magnetronplasma ausgebildet wird. Das Target 9 umfasst einen Targetgrundkörper 10, der ursprünglich ebenfalls aus einem massiven Block des Materials Titan bestand. Aus diesem massiven Block wurde jedoch in den Oberflächenbereichen, die in Fig. 2 ohne Schraffur dargestellt sind, Titanmaterial herausgefräst. Dabei wurden in diesen Bereichen zwei Drittel der Targetdicke abgetragen. Es ist nicht erfindungswesentlich, in solchen Bereichen genau zwei Drittel der Targetdicke zu entfernen. Alternativ können auch alle anderen Dickenbereiche abgetragen werden. Vorteilhaft ist es aber für

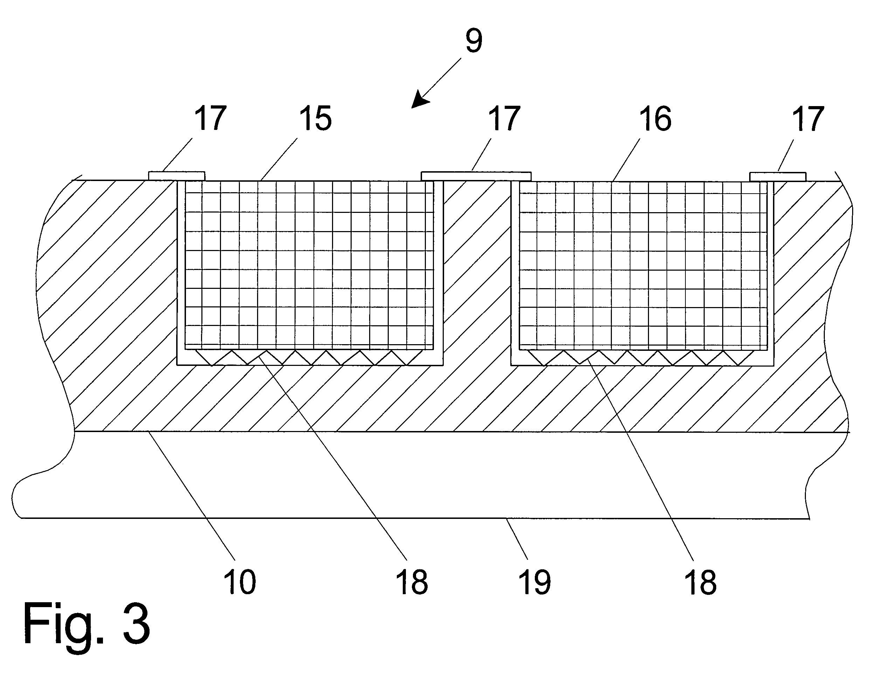

In der Fig. 3 wurden die Verbindungselemente 17 der Einfachheit halber aufliegend auf der Targetgrundkörperoberfläche und den Teiltargetoberflächen dargestellt. Bei der Umsetzung in der Praxis ist jedoch vorteilhaft, die Verbindungselemente 17 derart in das Material von Targetgrundkörper und den Teiltargets abzusenken, so dass die Oberflächen vom Targetgrundkörper, von den Teiltargets und den Verbindungselementen eine Ebene ausbilden, damit über dieser Ebene auch gleichmäßige Plasmabedingungen geschaffen werden können.

Mit derartigen Targets 9 wurde der Beschichtungsvorgang C durchgeführt. In der Vakuumkammer wurde hierbei wiederum ein Druck von 3 Pa aufrechterhalten. Das Gasgemisch, das diesen Druck erzeugt, besteht zu 23 % aus Argon, zu 35 % aus Sauerstoff und zu 42 % aus HMDSO. Von dem siliziumhaltigen Monomer HMDSO werden 150 sccm in die Vakuumkammer zugeführt. Im Magnetronplasma wird eine elektrische Leistung von 7 kW umgesetzt. Wie bereits oben beschrieben, wurden Anzahl und Art der mechanischen Federelemente 18 derart ausgebildet, dass diese Teiltargets 11 bis 16 während des Beschichtungsvorgangs eine Temperatur von mehr als 500 °C erreichen. Der Targetgrundkörper 10 wurde hingegen während des Beschichtungsvorgangs mittels des Kühlkörpers 19 auf eine Temperatur von 120 °C gekühlt. Bei einer Bewegungsgeschwindigkeit eines zu beschichtenden Substrates von 1 Meter pro Minute wurde auf dem Substrat eine siliziumhaltige Schicht von 500 nm Dicke abgeschieden. Dabei wurden Arcs mit einer Häufigkeit von maximal 20 Arcs pro Sekunde erfasst.

Auch wenn der Erfindungsgegenstand in den Ausführungsbeispielen nur anhand des Abscheidens von siliziumhaltigen Schichten durch den Einlass von HMDSO beschrieben wurde, sei erwähnt, dass eine erfindungsgemäße Vorrichtung auch beim Abscheiden aller anderer mittels eines PECVD-Prozesses abscheidbarer Schichtmaterialien verwendet werden kann. Beispielhaft seinen hier das Abscheiden zinkhaltiger Schichten, durch den Einlass zinkhaltiger Monomere wie Diethylzink; aluminiumhaltiger Schichten, durch den Einlass aluminiumhaltiger Monomere wie AlCl₃, Al(CH₃)₃ und Al(C₂H₅)₃; oder titanhaltiger Schichten, durch den Einlass titanhaltiger Monomere wie TiCl₄, Tetradimethylaminotitan (TDMAT) oder Titanisopropoxid, genannt. Ebenfalls können für das Abscheiden silizumhaltiger Schichten auch andere Monomere außer HMDSO verwendet werden, wie beispielsweise Tetraethylorthosilicat (TEOS), Tetramethylsilan (TMS), Silan (SiH₄), Hexamethyldisilazane (HMDSN). Ferner können auch noch Gase wie H₂, N₂, NH₃, H₂O in Kombination mit verschiedenen oben genannter Monomere in die Vakuumkammer eingelassen werden, wenn die darin enthaltenen Elemente für die Schichtbildung benötigt werden.

## Patentansprüche

1. Verfahren zum Abscheiden einer Schicht auf einem Substrat (2) innerhalb einer Vakuumkammer (1) mittels plasmaunterstützter chemischer Dampfabscheidung, wobei durch mindestens einen Einlass (3) zumindest ein Monomer in die Vakuumkammer eingelassen wird und wobei mittels mindestens eines mit einem Target bestückten Magnetrons (4) ein Plasma erzeugt wird, **dadurch gekennzeichnet, dass** das Target (5; 9) während des Abscheidens der Schicht zumindest in einem Bereich auf eine Temperatur von mindestens 300 °C erhitzt wird.

2. Verfahren nach Anspruch 1, **dadurch gekennzeichnet, dass** das Target (5; 9) während des Abscheidens der Schicht zumindest in einem Bereich auf eine Temperatur von mindestens 500 °C erhitzt wird.

3. Verfahren nach Anspruch 1 oder 2, **dadurch gekennzeichnet, dass** das Target (9) aus mehreren Teiltargets (10; 11; 12; 13; 14; 15; 16) aufgebaut wird.

4. Verfahren nach Anspruch 3, **gekennzeichnet durch** eine Kühleinrichtung (19) zum Kühlen der Teiltargets (10; 11; 12; 13; 14; 15; 16), wobei zumindest bei einem Teiltarget (11; 12; 13; 14; 15; 16) der Wärmeübergang zur Kühleinrichtung (19) hin schlechter ausgebildet wird als bei einem anderen Teiltarget (10).

5. Verfahren nach Anspruch 3 oder 4, **dadurch gekennzeichnet, dass** zumindest ein Teiltarget mit einer schlechteren Wärmeleitfähigkeit gegenüber einem anderen Teiltarget ausgebildet wird.

6. Verfahren nach einem der Ansprüche 3 bis 5, **dadurch gekennzeichnet, dass** zumindest ein Teiltarget als Targetgrundkörper (10) ausgebildet wird, an dessen sputterbarer Oberfläche zumindest in einem Bereich ein weiteres Teiltarget (11; 12; 13; 14; 15; 16) einfügt wird.

7. Verfahren nach Anspruch 6, **dadurch gekennzeichnet, dass** der Wärmeübergang vom Targetgrundkörper (10) zum Teiltarget (11; 12; 13; 14; 15; 16) einstellbar ist.

8. Verfahren nach Anspruch 6, **dadurch gekennzeichnet, dass** zwischen dem Targetgrundkörper (10) und dem Teiltarget (11; 12; 13; 14; 15; 16) zumindest ein mechanisches Federelement angeordnet wird.

## Claims

1. Method for depositing a coating onto a substrate (2) inside a vacuum chamber (1) by means of plasma-assisted chemical vapour deposition, wherein at least one monomer is introduced into the vacuum chamber via at least one inlet (3), and wherein a plasma is generated using at least one magnetron (4) fitted with a target, **characterized in that** at least one region of the target (5; 9) is heated to a temperature of at least 300°C during deposition of the coating.

2. Method according to Claim 1, **characterized in that** at least one region of the target (5; 9) is heated to a temperature of at least 500°C during deposition of the coating.

3. Method according to Claim 1 or 2, **characterized in that** the target (9) is built up of multiple target parts (10; 11; 12; 13; 14; 15; 16).

4. Method according to Claim 3, **characterized by** a cooling device (19) for cooling the target parts (10; 11; 12; 13; 14; 15; 16), wherein, at least for one target part (11; 12; 13; 14; 15; 16), the transfer of heat to the cooling device (19) is designed to be worse than for another target part (10).

5. Method according to Claim 3 or 4, **characterized in that** at least one target part is designed with worse thermal conductivity than another target part.

6. Method according to one of Claims 3 to 5, **characterized in that** at least one target part is designed as a target main body (10), another target part (11; 12; 13; 14; 15; 16) being introduced into at least one region of the sputterable surface of the former.

7. Method according to Claim 6, **characterized in that** the transfer of heat from the target main body (10) to the target part (11; 12; 13; 14; 15; 16) is adjustable.

8. Method according to Claim 6, **characterized in that** at least one mechanical spring element is arranged between the target main body (10) and the target part (11; 12; 13; 14; 15; 16).

## Revendications

1. Procédé de dépôt d'une couche sur un substrat (2) à l'intérieur d'une chambre sous vide (1) par dépôt chimique de vapeur soutenu par plasma, dans lequel au moins un monomère est introduit dans la chambre sous vide par au moins une admission (3) et un plasma est formé au moyen d'au moins un magnétron (4) équipé d'une cible,
**caractérisé en ce que**
au moins une partie de la cible (5; 9) est chauffée à une température d'au moins 300°C pendant le dépôt de la couche.

2. Procédé selon la revendication 1, **caractérisé en ce que** la cible (5; 9) est chauffée à une température de l'ordre d'au moins 500°C pendant le dépôt de la couche.

3. Procédé selon les revendications 1 ou 2, **caractérisé en ce que** la cible (9) est constituée de plusieurs parties (10; 11; 12; 13; 14; 15; 16) de cible.

4. Procédé selon la revendication 3, **caractérisé par** un dispositif de refroidissement (19) qui refroidit la cible partielle (10; 11; 12; 13; 14; 15; 16), le transfert de chaleur d'au moins une cible partielle (11; 12; 13; 14; 15; 16) vers le dispositif de refroidissement (19) étant moins bon que sur une autre cible partielle (10).

5. Procédé selon les revendications 3 ou 4, **caractérisé en ce qu'**au moins une cible partielle présente une conductivité thermique moins bonne qu'une autre cible partielle.

6. Procédé selon l'une des revendications 3 à 5, **caractérisé en ce qu'**au moins une cible partielle est configurée comme corps de base (10) de cible sur au moins une partie de la surface pulvérisable duquel est insérée une autre cible partielle (11; 12; 13; 14; 15; 16).

7. Procédé selon la revendication 6, **caractérisé en ce que** le transfert de chaleur du corps de base (10) de cible à la cible partielle (11; 12; 13; 14; 15; 16) est ajustable.

8. Procédé selon la revendication 6, **caractérisé en ce qu'**au moins un élément mécanique à ressort est disposé entre le corps de base (10) de la cible et la cible partielle (11; 12; 13; 14; 15; 16).
